Europäisches Patentamt

European Patent Office

Office européen des brevets

(19)

(11) Veröffentlichungsnummer: **0 034 223**
**A1**

(12) # EUROPÄISCHE PATENTANMELDUNG

(21) Anmeldenummer: 80200238.6

(22) Anmeldetag: 14.03.80

(51) Int. Cl.³: **H 01 L 23/46**

(30) Priorität: 18.02.80 CH 1292/80

(43) Veröffentlichungstag der Anmeldung:
26.08.81 Patentblatt 81/34

(84) Benannte Vertragsstaaten:
AT BE CH DE FR GB IT LU NL SE

(71) Anmelder: BBC Brown, Boveri & Cie.
(Aktiengesellschaft)

CH-5401 Baden(CH)

(72) Erfinder: Kloss, Albert
Kornweg 5
CH-5415 Nussbaumen(CH)

(54) **Luftkanal zur Kühlung von Halbleiterelementen.**

(57) Ein Luftkanal (1) zur Kühlung von Halbleiterelementen (8) ist in seiner Längsrichtung in wenigstens einer Zone mit einem veränderlichen Querschnitt, vorzugsweise mit einem in Richtung (4) der Luftströmung abnehmenden Querschnitt ausgebildet. Der Vorteil dieser Lösung ist darin zu sehen, dass alle im Luftkanal (1) angeordneten Halbleiterelemente (8) so gekühlt werden, dass sie wenigstens annähernd gleiche Betriebstemperaturen aufweisen. Somit können sie gut ausgelastet werden. Die erforderliche Kühlluftmenge wird auf einen wirtschaftlichen Wert reduziert.

Der Luftkanal (1) ist insbesondere zur Kühlung von Grossleistungs-Halbleiterelementen (8) bestimmt.

FIG. 1

EP 0 034 223 A1

Croydon Printing Company Ltd.

- 1 -

## Luftkanal zur Kühlung von Halbleiterelementen

Die vorliegende Erfindung betrifft einen Luftkanal gemäss dem Oberbegriff des Anspruchs 1.

Um die Ausnützung der Halbleiterelemente zu erhöhen, werden diese gekühlt. Die Kühlung ist insbesondere bei grossen Leistungen vorteilhaft. Die Halbleiterelemente, z.B. die Thyristoren, werden meistens beidseitig mit an sich bekannten Kühlern versehen und in der Reihe hintereinander in einen Luftkanal einmontiert. Die Luftströmung wird von einem Ventilator besorgt, der meistens in der Luftaustrittsöffnung des Luftkanals angeordnet ist. Der Luftkanal besteht aus gegenseitig parallelen Wänden, so dass sein Querschnitt in der Längsrichtung konstant ist. Die Kühlluft führt von den Halbleiterelementen über die Kühler Wärme ab, womit selbstverständlich die Temperatur der Kühlluft steigt. Weil der Kühleffekt u.a. von der Temperaturdifferenz zwischen der Temperatur des gekühlten Gegenstandes und der Kühlluft abhängig ist, werden die Halbleiterelemente in der Nähe der Lufteintrittsöffnung besser gekühlt als diejenigen in der Nähe der Luftaustrittsöffnung. Die strommässige Bemessung der Halbleiterelemente muss sich nach den wärmsten richten, so dass ein Teil der Halbleiterelemente

- 2 -

nicht voll ausgenützt werden kann.

Der im Anspruch 1 angegebenen Erfindung liegt die Aufgabe zugrunde, einen Luftkanal zu schaffen, der die strommässige Ausnützung der luftgekühlten Halbleiterelemente erhöht und die erforderliche Luftmenge auf einen wirtschaftlichen Wert reduziert.

Der Vorteil der Erfindung besteht insbesondere darin, dass alle im Luftkanal angeordneten Halbleiterelemente eine wenigstens annähernd gleiche Betriebstemperatur aufweisen, so dass sie bei einer wirtschaftlichen Kühlluftmenge gut ausgelastet werden können.

Es ist zweckmässig, wenn der Luftkanal in seiner Längsrichtung in wenigstens einer Zone einen in Richtung der Luftströmung abnehmenden Querschnitt aufweist. Diese Zone ist insbesondere in der Nähe der Luftaustrittsöffnung zweckmässig, wo die Kühlluft eine höhere Temperatur aufweist. Durch die Verjüngung des Luftkanals erreicht man eine schnellere Luftströmung und somit auch eine bessere Kühlung der Halbleiterelemente.

Es ist selbstverständlich, dass die Verjüngung des Luftkanals kontinuierlich über die ganze Länge ausgeführt werden kann. Ebenfalls kann man eine stufenweise Aenderung des Querschnitts des Luftkanals realisieren oder den Querschnitt nur in einer Zone ändern.

Die Erfindung wird im folgenden an Hand schematischer Zeichnungen näher erläutert.

- 3 -

Es zeigt

Fig. 1  einen vereinfachten Längsschnitt durch einen beispielsweisen erfindungsgemässen Luftkanal mit
Halbleiterelementen und

Fig. 2  den Schnitt II-II aus Fig. 1.

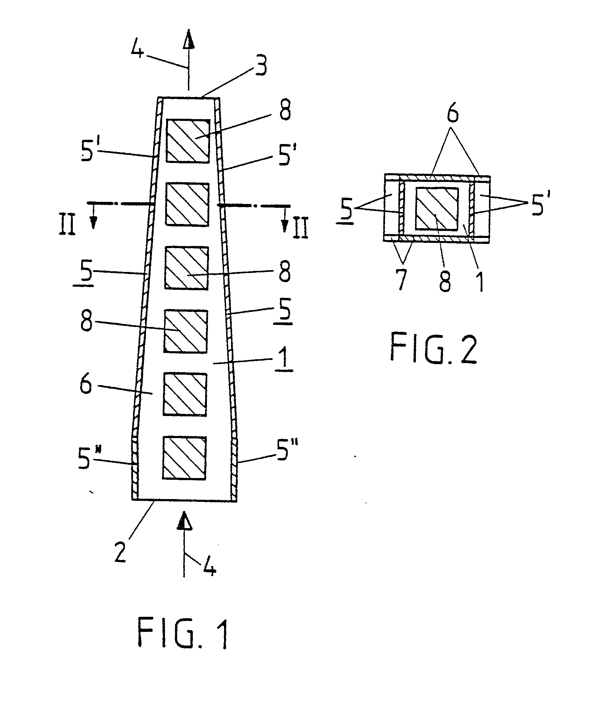

Alle zum unmittelbaren Verständnis der Erfindung nicht notwendigen Konstruktionsmerkmale, wie z.B. die Befestigungs-
und Tragelemente und der Ventilator, sind in den Zeichnungen fortgelassen worden. Gleiche Teile sind in Fig. 1 und 2
mit denselben Bezugsziffern versehen.

Gemäss Fig. 1 weist ein Luftkanal 1 eine Lufteintrittsöffnung 2 und eine Luftaustrittsöffnung 3 auf. Die Richtung 4
der Luftströmung ist mit Pfeilen gekennzeichnet. Der Luftkanal 1 ist durch Seitenwände 5, eine hintere Wand 6 und
eine vordere Wand 7 gebildet. Die vordere Wand 7 ist nur
in der Figur 2 gezeichnet. Die hintere Wand 6 und die vordere Wand 7 sind in dieser beispielsweisen Ausführungsform
parallel angeordnet. Der abnehmende Querschnitt des Luftkanals 1 ist mit zusammenlaufend angeordneten Teilen 5'
der Seitenwände 5 gebildet. Die Teile 5" der Seitenwände 5,
welche an die Lufteintrittsöffnung 2 angrenzen, sind parallel angeordnet. Der Luftkanal 1 weist also zwischen den
Teilen 5" einen konstanten Querschnitt auf. Mit der Bezugsziffer 8 sind Einheiten bezeichnet, die gekühlt werden
sollen und die z.B. je aus einem Thyristor und zwei beidseitig des Thyristors angeordneten Kühlern gebildet sind.

- 4 -

Es ist selbstverständlich, dass sowohl die Anzahl der Luftkanäle 1 als auch die Anzahl der in einem Luftkanal 1 angeordneten Halbleiterelemente 8 beliebig gewählt werden kann.

Bei einem erfindungsgemässen Luftkanal 1 wurden acht beidseitig mit Kühlern versehene Thyristoren 8 verwendet. Bei einer Lufteintrittsöffnung 2 mit Abmessungen 250 mm x 270 mm und einer Luftaustrittsöffnung 3 mit Abmessungen 170 mm x 270 mm war die Kühlluftmenge 0,36 $m^3$/s. In diesem Fall wurde ein Druckabfall von 30 mm $H_2O$ gemessen, so dass die Temperaturerhöhung der Kühlluft infolge der Druckänderung unbedeutend war. Der gemessene thermische Widerstand der einzelnen Halbleiterelemente 8 war innerhalb der Grenzwerte von 0,07 bis 0,08°C/W.

**0034223**
14/80

B e z e i c h n u n g s l i s t e
─────────────────────────────────

1       Luftkanal

2       Lufteintrittsöffnung

3       Luftaustrittsöffnung

4       Richtung der Luftströmung

5       Seitenwände des Luftkanals 1

5'      zusammenlaufend angeordnete Teile
        der Seitenwände 5

5"      parallel angeordnete Teile der
        Seitenwände 5

6       hintere Wand des Luftkanals 1

7       vordere Wand des Luftkanals 1

8       Halbleiterelemente - Thyristoren -
        ev. mit Kühlern versehen

0034223
14/80

Patentansprüche

1. Luftkanal zur Kühlung von Halbleiterelementen, welche in diesem Luftkanal angeordnet sind, wobei der Luftkanal mit mindestens einem Ventilator versehen ist, dadurch gekennzeichnet, dass der Luftkanal (1) in seiner Längsrichtung in wenigstens einer Zone einen veränderlichen Querschnitt aufweist.

2. Luftkanal nach Anspruch 1, dadurch gekennzeichnet, dass er in seiner Längsrichtung in wenigstens einer Zone einen in Richtung (4) der Luftströmung abnehmenden Querschnitt aufweist.

FIG. 1

FIG. 2

Europäisches
Patentamt

**EUROPÄISCHER RECHERCHENBERICHT**

| EINSCHLÄGIGE DOKUMENTE | | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| X | IBM TECHNICAL DISCLOSURE BULLETIN, Band 9, Nr. 9, Februar 1967, New York, US, R.C. CHU: "Converging air flow cooling", Seite 1244 <br><br> * Seite 1244 * <br><br> -- <br><br> IBM TECHNICAL DISCLOSURE BULLETIN, Band 10, Nr. 11, April 1968, New York, US, G.R. WITTS: "Air-cooled circuit package", Seite 1809 <br><br> * Seite 1809 * <br><br> ---- | 1,2 <br><br><br><br><br><br><br> 1,2 | H 01 L 23/46 <br><br><br><br><br><br><br><br><br><br><br> **RECHERCHIERTE SACHGEBIETE (Int. Cl.³)** <br><br> H 01 L 23/46 <br> H 05 K 7/20 |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 02-12-1980 | DE RAEVE |

EPA form 1503.1 06.78